# EUROPEAN PATENT APPLICATION

(11) **EP 4 746 628 A1**
(43) Date of publication of application: **20.05.2026**
(21) Application number: 25217033.7
(22) Date of filing: 19.11.2025
(51) Int. Cl.: H10D 30/01, H10D 30/60, H10D 64/27

(54) **LATERAL ORIENTED METAL-OXIDE-SEMICONDUCTOR DEVICE AND A METHOD OF MANUFACTURING LATERAL ORIENTED METAL-OXIDE-SEMICONDUCTOR**

(30) Priority: 19.11.2024 NL 2039118
(71) Applicant: Nexperia B.V., 6534 AB Nijmegen (NL)
(72) Inventor: Kumar, Manoj, Hamburg (DE); Khaund, Chinmoy, Hamburg (DE); Ong, Kilian, Hamburg (DE)
(74) Representative: Pjanovic, Ilija

(57) **Abstract**

According to a first example of the disclosure a single cell lateral oriented Metal-Oxide-Semiconductor device is proposed. The device comprises a semiconductor comprising a first surface; a first region having a first conductivity type; an at least one pair of trenches, wherein each trench extends from the first surface into the first region, each of the trench comprising an insulating element and a conductive element, wherein the insulating element is arranged in between the conductive element and the first region, and wherein the insulating element has a substantially uniform width; a second region having a second conductivity type being different from the first conductivity type, wherein the second region extends from the first surface into the first region and is located on an outer side of the pair of trenches and adjacent to the trench, and a third region having a second conductivity type being different from the first conductivity type, wherein the third region extends from the first surface into the first region and is located in between trenches and adjacent to the trench, and an insulating region on the first surface comprising openings to provide electrical contacts to the second and third region.

This disclosure also relates to a method of manufacturing a lateral oriented Metal-Oxide-Semiconductor device.

## Description

### TECHNICAL FIELD

The present disclosure relates to the field of semiconductors and, more specifically, to the field of lateral Metal-Oxide-Semiconductor Field Effect Transistors.

### BACKGROUND OF THE DISCLOSURE

The present disclosure generally relates to power Metal Oxide Semiconductor Field Effect Transistors, MOSFETs, and more particularly to such device used in synchronous rectifier circuit applications and exhibiting low on-resistance, fast switching speed, high voltage capability, and bidirectionality in AC circuits.

Employing a trench gate is known especially in vertically oriented MOSFET devices, however the use of a trench-gate in lateral devices has not been substantially explored. It is understood that by using the term "lateral devices" the present disclosure relates to a field of devices wherein the channel that is formed during a conduction state of the MOSFET device is substantially lateral, and not vertical.

A known prior art document US2013207172A1 discloses a trench MOSFET comprising a top side drain region in a wide trench in a termination area besides a BV sustaining area, wherein the top side drain comprises a top drain metal connected to an epitaxial layer and a substrate through a plurality of trenched drain contacts, wherein the wide trench is formed simultaneously when a plurality of gate trenches are formed in an active area, and the trenched drain contacts are formed simultaneously when a trenched source-body contact is formed in the active area.

Accordingly, it is a goal of the present disclosure to provide an improved MOSFET device operating with more than 40V BVDS (Break Down Voltage Drain to Source).

### SUMMARY OF THE DISCLOSURE

According to a first example of the disclosure a single cell lateral oriented Metal-Oxide-Semiconductor device is proposed, the device comprising a semiconductor which comprises:
- a first surface;
- a first region having a first conductivity type;
- an at least one pair of trenches, wherein each trench extends from the first surface into the first region, each of the trench comprising an insulating element and a conductive element, wherein the insulating element is arranged in between the conductive element and the first region, and wherein the insulating element has a substantially uniform width;
- a second region having a second conductivity type being different from the first conductivity type, wherein the second region extends from the first surface into the first region and is located on an outer side of the pair of trenches and adjacent to the trench, and
- a third region having a second conductivity type being different from the first conductivity type, wherein the third region extends from the first surface into the first region and is located in between trenches and adjacent to the trench, and
- an insulating region on the first surface comprising openings to provide electrical contacts to the second and third region.

Preferably the first region is a moderately doped substrate.

Preferably the first region is an EPI layer arranged over a substrate.

Preferably the semiconductor device further comprises an electrical contact arranged to provide electrical contact to the conductive element in the trench.

Preferably the second region is heavily doped.

Preferably the third region is heavily doped.

Preferably the insulating region is arranged to insulate the conductive element along the first surface.

Preferably the third region's width is in range from 0,3 µm to 3,5 µm.

Preferably each of the second region forms a source terminal and the third region forms a drain terminal of a MOS Field Effect Transistor device, and wherein the conductive element forms a gate terminal of the MOSFET device.

According to this example an improved lateral CSP device is disclosed. Eliminating the use of sinker by creating pseudo-lateral MOSFET into a VD-MOSFET MOSFET. This improves high voltage levels irrespective of EPI thickness thus overcoming the sinker limitations.

According to a second example of the disclosure, a multiple cell MOS Field Effect Transistor device comprises two or more single cell lateral oriented Metal-Oxide-Semiconductor devices arranged next to each other, forming a multi trench device having at least two third regions.

According to this example an improved MOSFET device is disclosed. Split Drain and Source are into multiple cells reduces current crowding and back side impact on Ron.

This disclosure also relates to a method of manufacturing a lateral oriented Metal-Oxide-Semiconductor device, wherein the device has a first surface, and wherein the method comprises the steps of:
A. providing a first region having a first conductivity type;
B. providing an at least one third region having a second conductivity type being different from the first conductivity type, wherein the third region extends from the first surface into the first region;
C. etching an at least one pair of trenches extending from the first surface into the first region wherein the at least one pair of trenches have the at least one third region located between trenches of the at least one pair of trenches;
D. providing an insulating element of substantially uniform width in trenches;
E. providing a conductive element in trenches;
F. providing a second region having a second conductivity type being different from the first conductivity type, wherein the second region extends from the first surface into the first region and is located on the outer side of the at least one pair of trenches and adjacent to the trench and are not in contact with one another; and
G. providing an insulating region on the first surface comprising openings for providing electrical contact to the second and third region.

Preferably the first region is provided on top of a substrate.

Preferably the method further comprises a step of providing a metallic contacts suitable for forming electrodes by means of a metallization process flow.

Preferably the third region's width is in range from 0,3 µm to 3,5 µm.

### BRIEF DESCRIPTION OF THE DRAWINGS

The disclosure will now be discussed with reference to the drawings which show in:
- Figure 1: shows the cross section of the single cell lateral oriented Metal-Oxide-Semiconductor device.
- Figure 2: shows the method of manufacturing a lateral oriented Metal-Oxide-Semiconductor device after step A.
- Figure 3: shows the method of manufacturing a lateral oriented Metal-Oxide-Semiconductor device after step B.
- Figure 4: shows the method of manufacturing a lateral oriented Metal-Oxide-Semiconductor device after step D.
- Figure 5: shows the method of manufacturing a lateral oriented Metal-Oxide-Semiconductor device after step E.
- Figure 6: shows the method of manufacturing a lateral oriented Metal-Oxide-Semiconductor device after step F.
- Figure 7: shows the method of manufacturing a lateral oriented Metal-Oxide-Semiconductor device after step G.
- Figure 8: shows the cross section of the Metal-Oxide-Semiconductor device comprising more than one cell of the lateral oriented Metal-Oxide-Semiconductor device.
- Figure 9: shows the cross section of the Metal-Oxide-Semiconductor device comprising more than one cell of the lateral oriented Metal-Oxide-Semiconductor device having conductive elements of a different depth.
- Figure 10: shows the cross section of the Metal-Oxide-Semiconductor device having the third region formed deeper than at least one conductive element.
- Figure 11: shows the cross section of the lateral oriented Metal-Oxide-Semiconductor device comprising the split gate architecture.
- Figure 12: shows the cross section of the lateral oriented Metal-Oxide-Semiconductor device having the split gate architecture with the third region formed deeper than at least one second region.
- Figure 13: shows the cross section of the lateral oriented Metal-Oxide-Semiconductor device having the split gate architecture with the third region formed wider than at least one second region.
- Figure 14: shows the top view of the lateral oriented Metal-Oxide-Semiconductor device having Drain and Source area split into multiple cells.

### DETAILED DESCRIPTION OF THE DISCLOSURE

For a proper understanding of the disclosure, in the detailed description below corresponding elements or parts of the disclosure will be denoted with identical reference numerals in the drawings. The present disclosure is not limited to the disclosed examples.

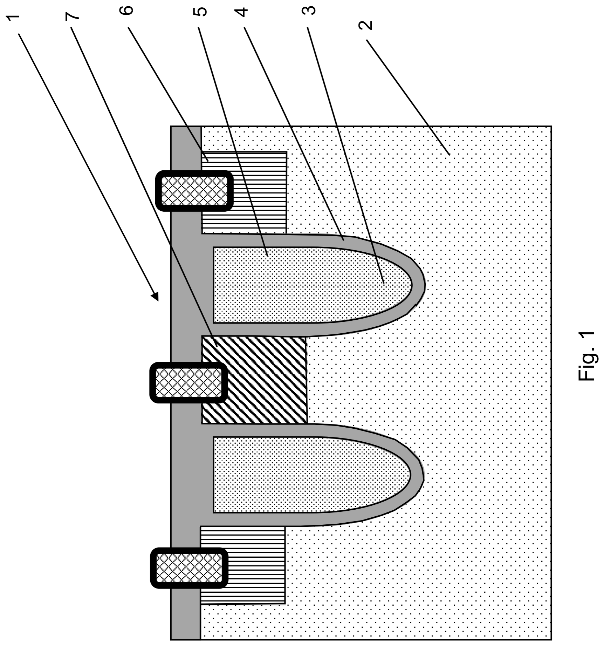

An example of a single cell of a lateral oriented Metal-Oxide-Semiconductor device is shown in Figure 1. According to this example the single cell of the lateral oriented Metal-Oxide-Semiconductor device comprises a semiconductor body having a first surface 1 located on the top of the device. The semiconductor body comprises a first region 2 having a first conductivity type. In the example, this region is a N/P EPI layer. In the first region 2 at least one pair of trenches 3 is provided. Each trench 3 extends from the first surface 1 (seen from the top of the device) recessed into the first region 2. The trenches 3 comprise an insulating element 4 and a conductive element 5 which is typically made out of doped poly-silicon material.

The insulating element 4 is arranged in between the conductive element 5 and the first region 2, and the insulating element 4 has a substantially uniform width. The semiconductor body comprises also a second region 6 having a second conductivity type P/N being different from the first conductivity type. The second region 6 extends from the first surface 1 (seen from the top) into the first region 2 (it is recessed into the first region 2). The second region 6 is located on an outer side of the pair of trenches 3 and adjacent to the trench 3. The semiconductor body comprises further a third region 7 having a second conductivity type being different from the first conductivity type. The third region 7 extends from the first surface 1 (seen from the top) into the first region 2 (it is recessed into the first region 2). The third region 7 is located in between trenches 3 and adjacent to the trench 3.

The second region 6 and the third region 7 form the source S and drain D of the device respectively. It should be noted that the second region 6 and the third region 7 have a different conductivity type than the first region 2. For example, if the first region 2 has a conductivity of P-type, then both the second region 6 and the third region 7 have conductivity of n-type. The skilled persons also understand that the second region 6 and the third region 7 that form the source D and drain D region are to be heavily doped (1e16 ~ 5e17). Furthermore, the type of conductivity also depends on the channel type of the Metal-Oxide-Semiconductor device. For example, for an N-type device (MOSFET), the second region 6 and the third region 7 have a conductivity of n-type and the first region 2 is of p-type.

The semiconductor body comprises also an insulating region 8 on the first surface 1. The insulating region 8 comprises openings to provide electrical contacts 10 to the second region 6 and the third region 7. The surface of the device is insulated using a further insulating element 4. Suitable openings are brought into the further insulating element 4, which are designed to accommodate electrodes that contact the respective region. For example, electrode S forms the source electrode and is in contact with the second region 6. Electrode D forms the drain D and is in contact with the third region 7.

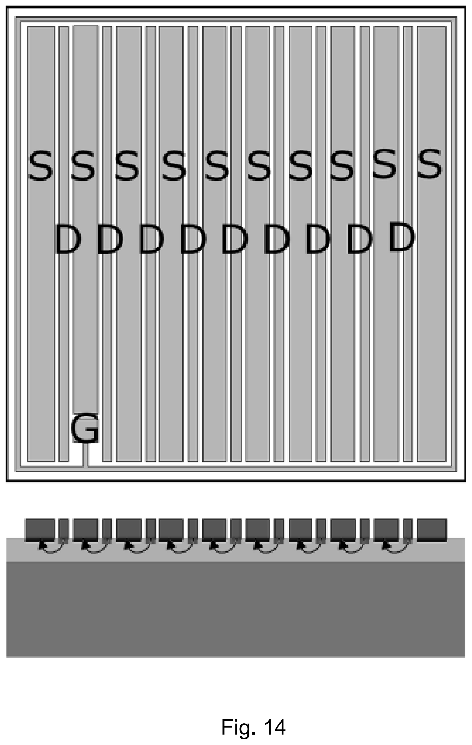

Such a device offers improvement in a reduced pitch arrangement by eliminating the impact of sinker implant. Advantageously, the device according to this disclosure can be used for all voltage classes so that the issue with area sacrificed for sinker region can also be eliminated using multi-layer front metal approach. The split of the Drain D and Source S areas into multiple cells (see Figure 14) provides reduction of current crowding and reduction of back side impact on Ron. Furthermore, the device according to this disclosure provides improvement in reduction of distribution resistance losses, as no back metal and/or low resistant substrate is required.

Accordingly, it is a goal of the present disclosure to provide an improved MOSFET device operating with more than 40V BVDS (Brake Down Voltage Drain D to Source S) irrespective of EPI thickness thus overcoming the sinker limitations.

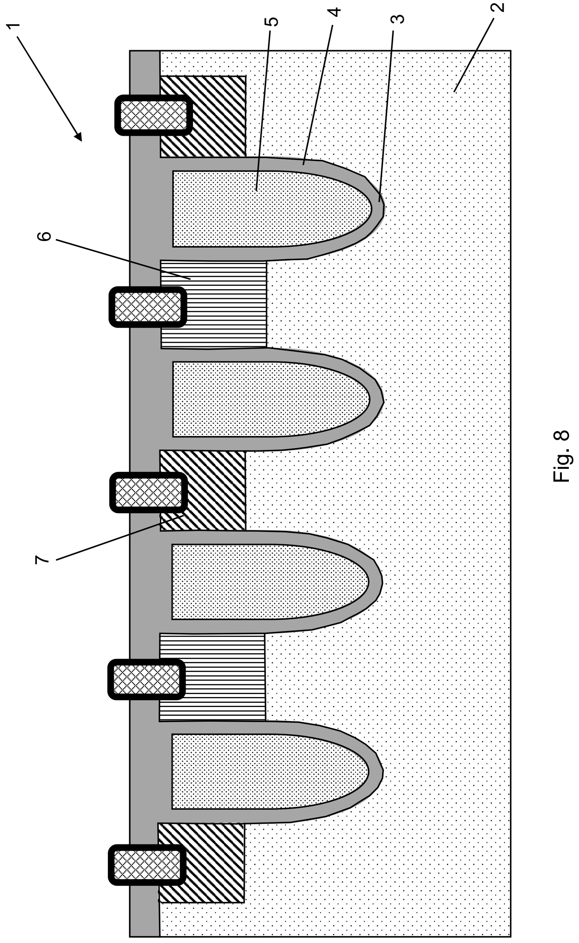

In another example of the disclosure, in Figure 8, a multi cell lateral oriented Metal-Oxide-Semiconductor device is disclosed. This device comprises more than one second region 6 and third region 7, having a plurality of S and D electrodes connected accordingly. The top view of such structure is also shown in Figure 14.

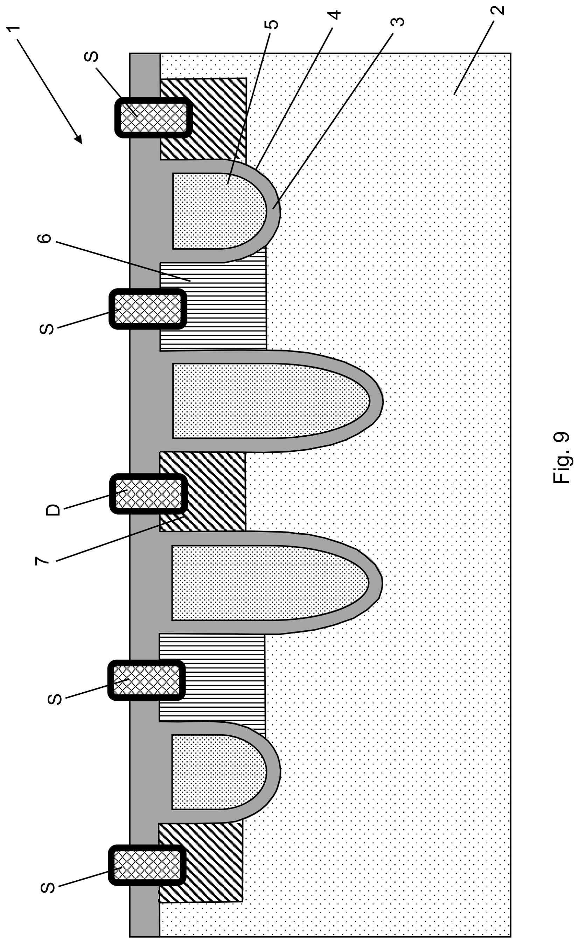

In another example of the disclosure, in Figure 9, a multi cell lateral oriented Metal-Oxide-Semiconductor device is disclosed. The device, according to this example comprises trenches 3 of a different depth.

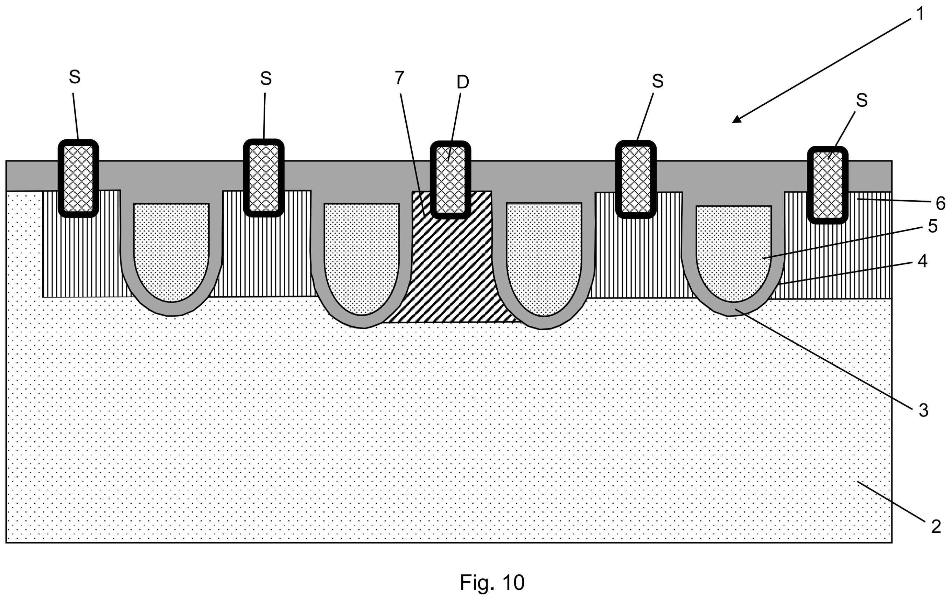

In another example of the disclosure, in Figure 10, a multi cell lateral oriented Metal-Oxide-Semiconductor device is disclosed. The device according to this example comprises the third region 7 formed deeper (seen from the top surface) than at least one conductive element 5.

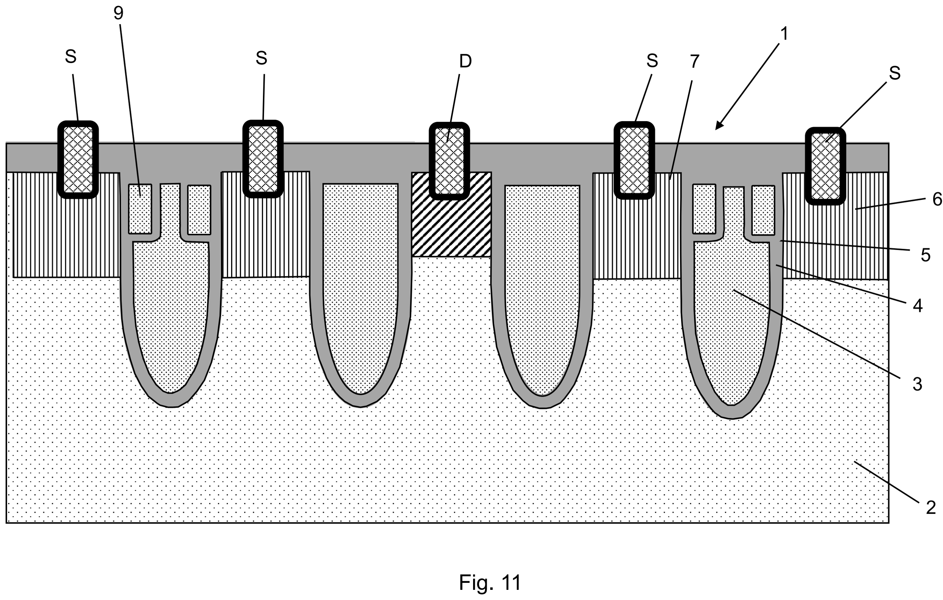

In another example of the disclosure, in Figure 11, a multi cell lateral oriented Metal-Oxide-Semiconductor device is disclosed. The device according to this example comprises the split gate 9 architecture.

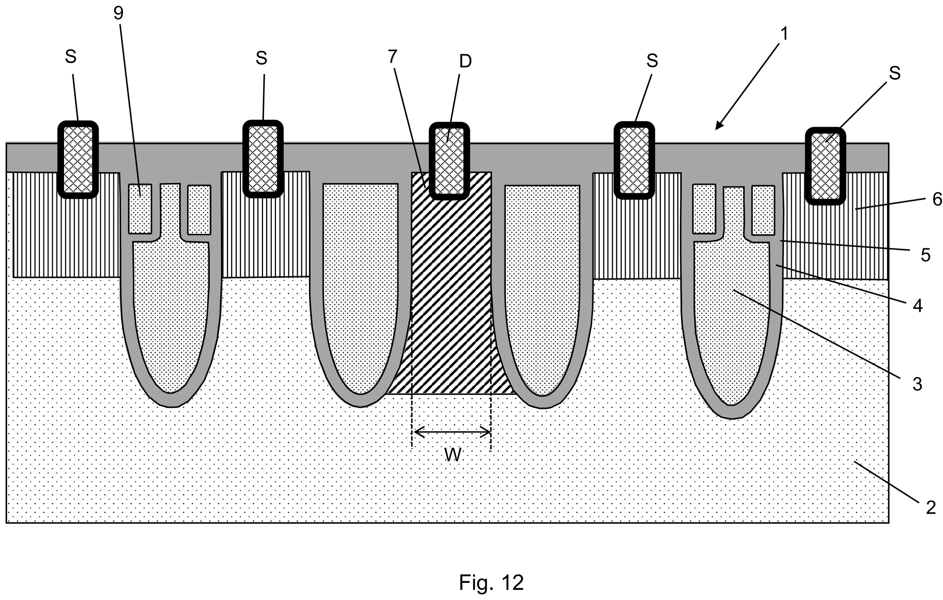

In another example of the disclosure, in Figure 12, a multi cell lateral oriented Metal-Oxide-Semiconductor device is disclosed. The device according to this example comprises the split gate 9 architecture and the third region 7 formed deeper (seen from the top surface) than at least one conductive second region 6.

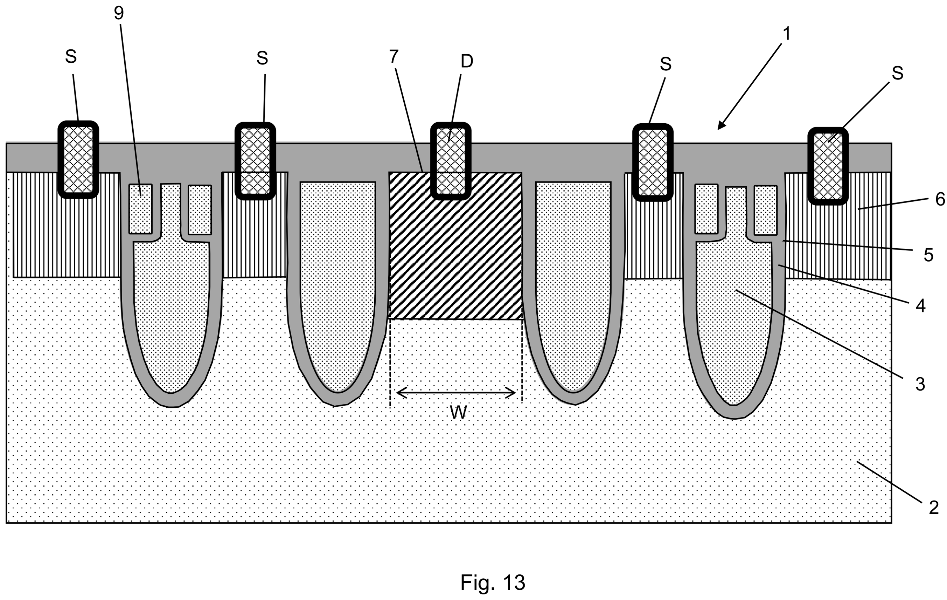

In another example of the disclosure, in Figure 13, a multi cell lateral oriented Metal-Oxide-Semiconductor device is disclosed. The device according to this example comprises the split gate 9 architecture and the third region 7 formed wider than at least one conductive second region 6.

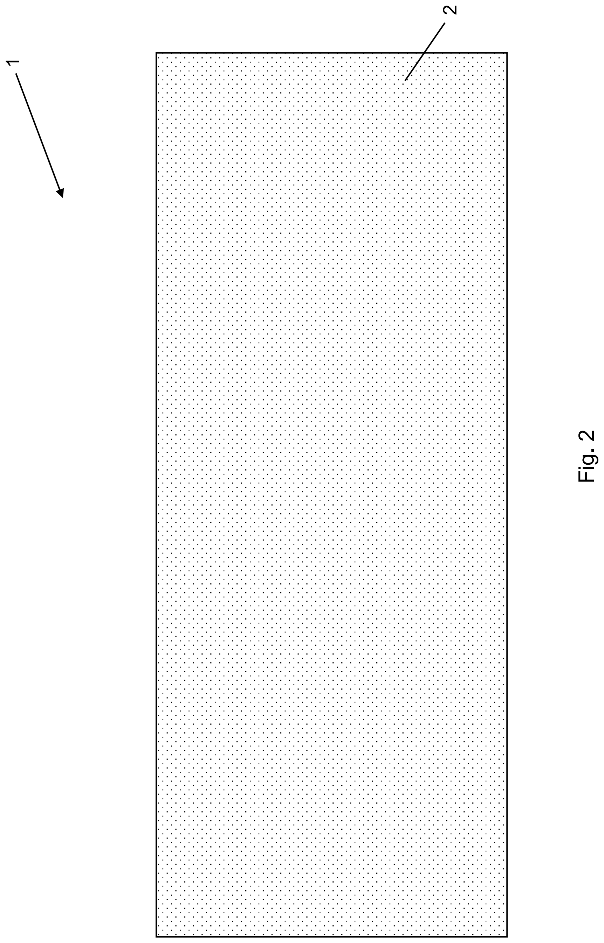

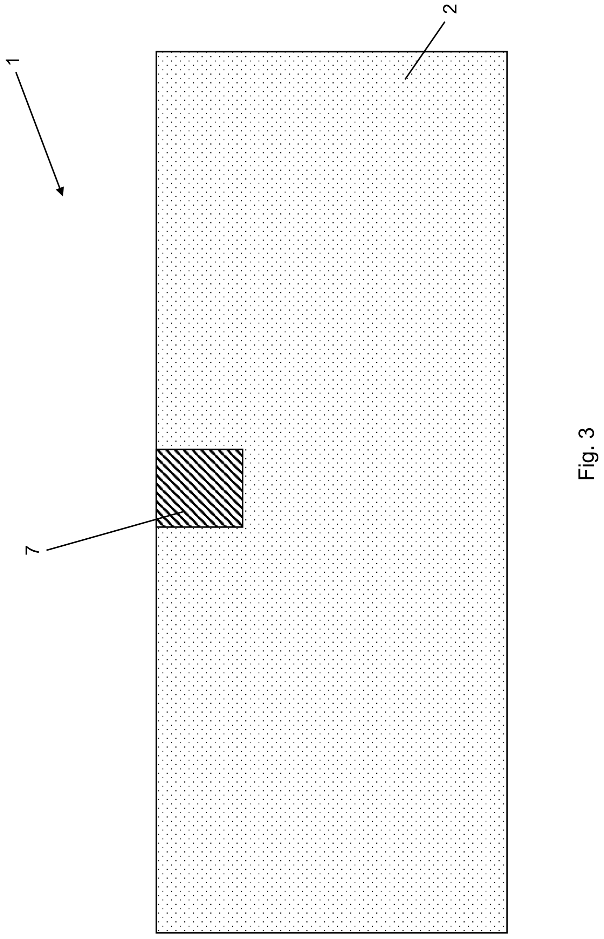

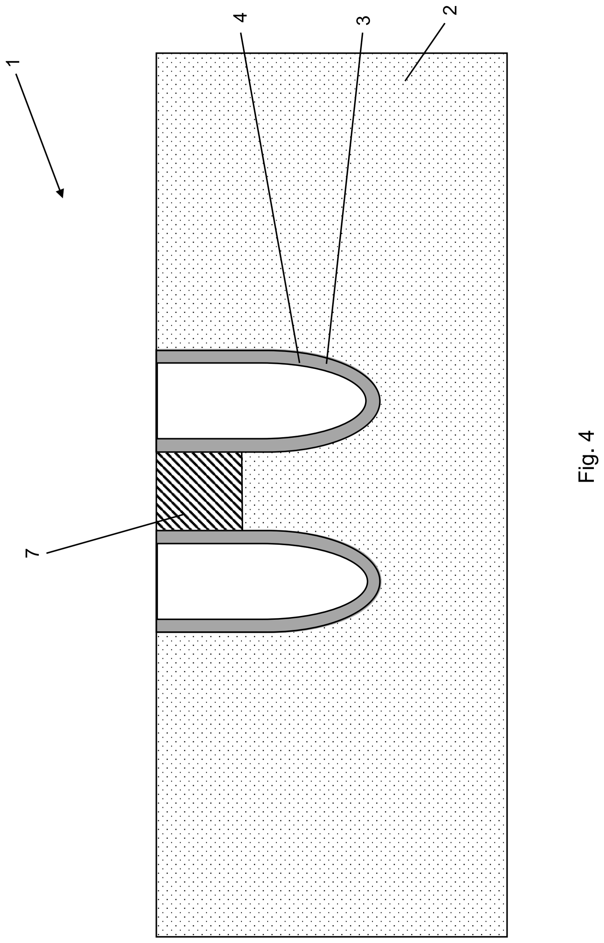

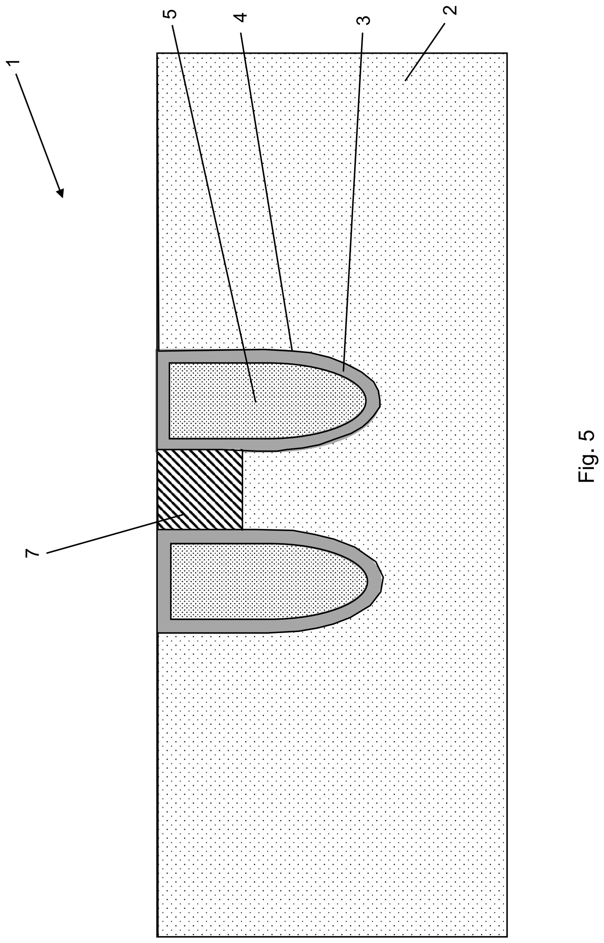

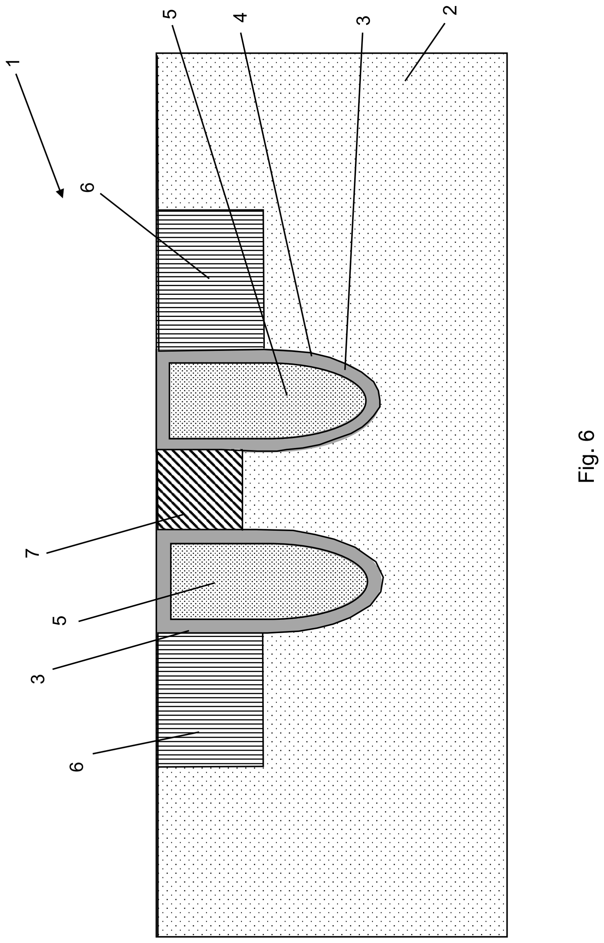

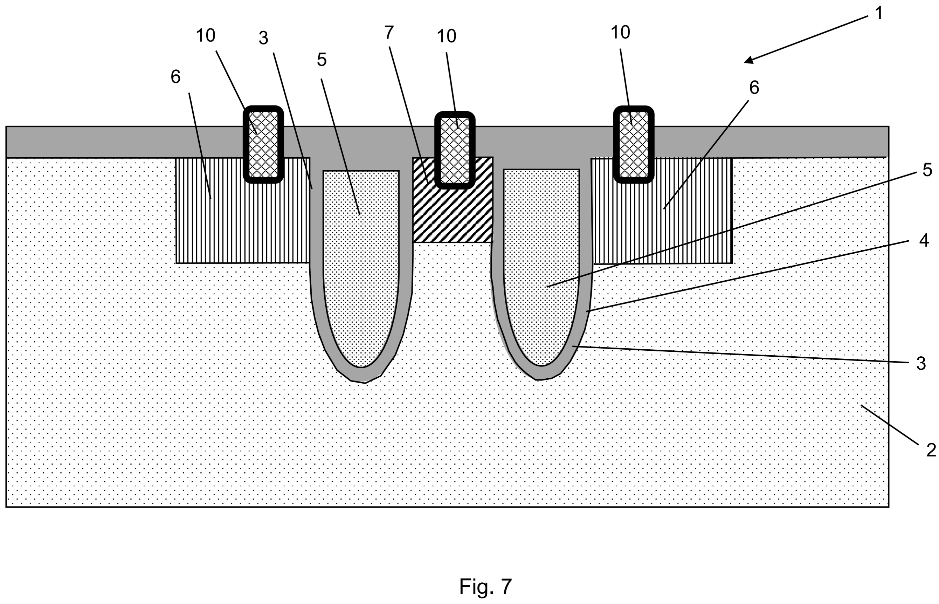

This disclosure also comprises a method of manufacturing a lateral oriented Metal-Oxide-Semiconductor device. In this example the method comprises step A. of providing a first region 2 having a first conductivity type (P/N). This step is illustrated in Figure 2. Figure 3 illustrates step B. of the method which is providing an at least one third region 7 having a second conductivity type being different from the first conductivity type, wherein the third region 7 extends from the first surface 1 into the first region 2. A further step C. implements etching an at least one pair of trenches 3 extending from the first surface 1 (seen from the top) into the first region 2 wherein one pair of trenches 3 have the third region 7 located between trenches 3 of the pair. Next step D. as illustrated in Figure 4 is performed and pertains to providing an insulating element 4 of substantially uniform width in the trenches 3. Figure 5 illustrates the next step E. of providing a conductive element 5 in the trenches 3. Following step E. is step F. that provides a second region 6 having a second conductivity type being different from the first conductivity type (P/N). The second region 6 extends from the first surface 1 into the first region 2 and is located on an outer side of the pair of trenches 3 and adjacent to the trench 3 and are not in contact with one another. Step F is illustrated in Figure 6. Figure 7 illustrates step G. of providing a further the on the first surface 1 comprising openings for providing electrical contact 10 to the second 6 and third region 7.

In another example of the disclosure the first region 2 is provided on top of a suitable substrate.

In another example of the disclosure the method further comprises a step of providing suitable metallic contacts for the electrodes (S, D) by means of a metallization process flow.

In another example of the disclosure the third region 7 width is formed in range from 0,3 µm to 3,5 µm.

### LIST OF REFERENCE NUMERALS USED

- 1: first surface
- 2: first region
- 3: trench
- 4: insulating element
- 5: conductive element
- 6: second region
- 7: third region
- 8: insulating region
- 9: split gate
- 10: electrical contact
- D: Drain
- S: Source

## Claims

1. A single cell lateral oriented Metal-Oxide-Semiconductor device comprising a semiconductor body comprising:
- a first surface;
- a first region having a first conductivity type;
- an at least one pair of trenches, wherein each trench extends from the first surface into the first region, each of the trenches comprises an insulating element and a conductive element, wherein the insulating element is arranged between the conductive element and the first region, and wherein the insulating element has a substantially uniform width;
- a second region having a second conductivity type being different from the first conductivity type, wherein the second region extends from the first surface into the first region and is located on an outer side of the pair of trenches and adjacent to the trench, and
- a third region having a second conductivity type being different from the first conductivity type, wherein the third region extends from the first surface into the first region and is located in between the trenches and adjacent to the trench, and
- an insulating region on the first surface comprising openings to provide electrical contacts to the second region and third region.

2. The semiconductor device according to claim 1, wherein the first region is a moderately doped substrate.

3. The semiconductor device according to claim 1, wherein the first region is an EPI layer arranged over a substrate.

4. The semiconductor device according to any of the previous claims and further comprises an electrical contact arranged to provide electrical contact to the conductive element in the trench.

5. The semiconductor device according to any of the previous claims, wherein the second region is heavily doped;

6. The semiconductor device according to any of the previous claims, wherein the third region is heavily doped.

7. The semiconductor device according to any of the previous claims, wherein the insulating region is arranged to insulate the conductive element along the first surface.

8. The semiconductor device according to any of the previous claims, wherein the third region width is in range from 0,3 µm to 3,5 µm.

9. The semiconductor device according to any of the previous claims, wherein each of the second regions forms a source terminal and the third region forms a drain terminal of a MOS Field Effect Transistor device, and wherein the conductive element forms a gate terminal of the MOSFET device.

10. A multiple cell MOS Field Effect Transistor device comprising two or more single cell lateral oriented Metal-Oxide-Semiconductor devices according to any of the claims from 1 to 9 arranged next to each other, forming a multi trench device having at least two third regions.

11. A method of manufacturing a lateral oriented Metal-Oxide-Semiconductor device according to any of the claims 1 - 10, wherein the device has a first surface, and wherein the method comprises the steps of:
A. providing a first region having a first conductivity type;
B. providing an at least one third region having a second conductivity type being different from the first conductivity type, wherein the third region extend from the first surface into the first region;
C. etching an at least one pair of trenches extending from the first surface into the first region wherein the at least one pair of trenches have the at least one third region located between trenches of the at least one pair of trenches;
D. providing an insulating element having substantially uniform width in the trenches;
E. providing a conductive element in the trenches;
F. providing a second region having a second conductivity type being different from the first conductivity type, wherein the second region extends from the first surface into the first region and is located on an outer side of the at least one pair of trenches and adjacent to the trench, and are not in contact with one another;
G. providing an insulating region on the first surface comprising openings for providing electrical contact to the second region and the third region.

12. The method according to claim 11, wherein the first region is provided on top of a substrate.

13. The method according to any of claims from 11 to 12, further comprises a step of providing a metallic contacts by means of a metallization process flow.

14. The method according to any of claims from 11 to 13, wherein the third region width is in range from 0,3 µm to 3,5 µm.
